# EUROPÄISCHE PATENTSCHRIFT

(11) **EP 3 884 287 B1**
(45) Veröffentlichungstag und Bekanntmachung des Hinweises auf die Patenterteilung: **06.03.2024**
(21) Anmeldenummer: 19797591.5
(22) Anmeldetag: 23.10.2019
(51) Int. Cl.: G01R 31/28, G01N 27/06

(54) **VERFAHREN ZUM FESTSTELLEN EINES ELEKTRISCHEN FEHLERS EINES LEITFÄHIGKEITSSENSORS UND LEITFÄHIGKEITSSENSOR**
METHOD FOR DETERMINING AN ELECTRICAL FAULT OF A CONDUCTIVITY SENSOR, AND CONDUCTIVITY SENSOR
PROCÉDÉ POUR DÉTECTER UN DYSFONCTIONNEMENT ÉLECTRIQUE AFFECTANT UN CAPTEUR DE CONDUCTIVITÉ, ET CAPTEUR DE CONDUCTIVITÉ CORRESPONDANT

(30) Priorität: 21.11.2018 DE 102018219952
(43) Veröffentlichungstag der Anmeldung: 29.09.2021
(73) Patentinhaber: Vitesco Technologies GmbH, 93055 Regensburg (DE)
(72) Erfinder: ZHANG, Hong, 81737 München (DE)
(74) Vertreter: Vitesco Technologies
(86) Internationale Anmeldenummer: PCT/EP2019/078825
(87) Internationale Veröffentlichungsnummer: WO 2020/104133

(56) Entgegenhaltungen:
- EP-A1- 3 312 600
- EP-A2- 1 089 072
- DE-A1-102012 106 384
- US-A1- 2017 052 243
- JIKUN YI ET AL: "The simulation of frequency-capacitance characteristics of fresh water conductivity sensor", NANO/MICRO ENGINEERED AND MOLECULAR SYSTEMS, 2009. NEMS 2009. 4TH IEEE INTERNATIONAL CONFERENCE ON, IEEE, PISCATAWAY, NJ, USA, 5. Januar 2009 (2009-01-05), Seiten 29-32, XP031470629, ISBN: 978-1-4244-4629-2

## Beschreibung

Die vorliegende Erfindung betrifft ein Verfahren zum Feststellen eines elektrischen Fehlers eines Leitfähigkeitssensors und einen Leitfähigkeitssensor, insbesondere ein Verfahren zum Feststellen eines elektrischen Fehlers eines Leitfähigkeitssensors und einen Leitfähigkeitssensor zum Erfassen der Leitfähigkeit eines Mediums, insbesondere eines flüssigen Mediums, wie beispielsweise Wasser, nach dem konduktiven Prinzip.

Konduktive Leitfähigkeitssensoren werden in vielfältigen Anwendungen zur Messung der Leitfähigkeit eines Mediums eingesetzt. Die bekanntesten konduktiven Leitfähigkeitssensoren sind die sogenannten Zwei- oder Vierelektrodensensoren.

Zweielektrodensensoren weisen zwei im Messbetrieb in das Medium eingetauchte und mit einer Gleich- oder Wechselspannung beaufschlagte Elektroden auf. Eine an die beiden Elektroden angeschlossene Messelektronik misst eine elektrische Impedanz der Leitfähigkeitsmesszelle, aus der dann anhand einer von durch die Geometrie und die Beschaffenheit der Messzelle gegebenen vorab bestimmten Zellkonstante ein spezifischer Widerstand bzw. ein spezifischer Leitwert des in der Messzelle befindlichen Mediums ermittelt wird.

Vierelektrodensensoren weisen vier im Messbetrieb in das Medium eingetauchte Elektroden auf, von denen zwei als sogenannte Strom- und zwei als sogenannte Spannungselektroden betrieben werden. Zwischen den beiden Stromelektroden wird im Messbetrieb eine Gleich- oder Wechselspannung angelegt und damit ein Gleich- oder Wechselstrom in das Medium eingespeist. Der eingespeiste Strom bewirkt eine zwischen den Spannungselektroden anliegende Potentialdifferenz, die durch eine vorzugsweise stromlose Messung bestimmt wird. Auch hier wird mittels einer an die Strom- und Spannungselektroden angeschlossenen Messelektronik, die sich aus dem eingespeisten Strom und der gemessenen Potentialdifferenz ergebende Impedanz der Leitfähigkeitsmesszelle bestimmt, aus der dann anhand einer von durch die Geometrie und die Beschaffenheit der Messzelle gegebenen vorab bestimmten Zellkonstanten ein spezifischer Widerstand bzw. ein spezifischer Leitwert des in der Messzelle befindlichen Mediums bestimmt wird.

Aus der EP 1 089 072 A2 ist ein Leitfähigkeitssensor bekannt, welcher ein kreiszylindrisches Gehäuse aufweist, wobei metallene Messelektroden planar an einer kreisflächenförmigen Stirnwandung des kreiszylinderartigen Gehäuses angeordnet sind. Die metallenen Messelektroden bilden dabei zwei Spannungselektroden und zwei Stromelektroden. Die Spannungselektroden sind kreisflächenförmig ausgebildet und von den zwei kreis- oder kreisringflächenförmigen, im Wesentlichen in einem Halbkreis angeordneten Stromelektroden umgeben.

Aus der US 4 227 151 A ist eine Messzelle zum Messen und Überwachen der elektrischen Leitfähigkeit einer Flüssigkeit bekannt. Diese Messzelle weist eine Vielzahl von kreisförmigen Elektroden auf, die wechselseitig im Abstand und elektrisch isoliert voneinander angeordnet sind. Wenigstens vier konzentrische kreisförmige Elektroden sind dabei in oder auf einer ebenen Oberfläche angeordnet und gegeneinander durch Bereiche aus elektrisch nichtleitendem Material getrennt. Die innerste der vier Elektroden ist dabei hohl ausgebildet, um ein temperaturempfindliches Element aufzunehmen.

Ein weiterer Leitfähigkeits-Messwertaufnehmer ist aus der EP 0 386 660 A1 bekannt. An der Stirnfläche eines zylindrischen Trägerkörpers aus Isolierstoff sind vier konzentrische Metallringe als Elektroden für den Leitfähigkeits-Messwertaufnehmer angebracht. Die Elektroden schließen dabei plan mit der Stirnfläche ab. Dabei sind die Elektroden mit einem größeren Querschnitt als Stromelektroden geschaltet, während die Elektroden mit einem geringeren Querschnitt als Spannungselektroden eingesetzt werden.

Ferner ist aus der DE 10 2010 042 637 A1 ein Leitfähigkeitssensor bekannt, bei dem die konzentrisch angeordneten Elektroden eine gleiche, konstante Fläche aufweisen.

Die DE 10 2012 106 384 A1 betrifft ein Verfahren zur Ermittlung zumindest einer Fehlfunktion eines konduktiven Leitfähigkeitssensors mit zumindest zwei Elektroden. Der darin offenbarte Leitfähigkeitssensor wird zur Messung der Leitfähigkeit eines Mediums eingesetzt. Das daraus bekannte Verfahren umfasst ein Anlegen einer ersten elektrischen Größe an die Elektroden, ein Messen zumindest einer zweiten elektrischen Größe an den Elektroden und ein Entscheiden ob eine Fehlfunktion vorliegt anhand der Messung der zweiten elektrischen Größe.

Bei den aus dem Stand der Technik bekannten Leitfähigkeitssensoren ist es bekannt, die ordnungsgemäße Funktionalität der Elektrik der Elektroden durch das Vorsehen von zusätzlichen elektrischen Schaltungen zu überprüfen. Bei z. B. Vierelektrodensensoren können zusätzliche elektrische Schaltungen für die Spannungselektroden vorgesehen werden. Dabei werden die Spannungselektroden jeweils mit einer Spannungsquelle über Spannungselemente verbunden. Bei einer ordnungsgemäßen Funktionalität der elektrischen Anbindung der Spannungselektroden ergibt sich eine Spannung, die kleiner als ein vorbestimmter Spannungsschwellenwert ist. Liegt jedoch eine Unterbrechung der elektrischen Anbindung der Spannungselektroden vor, steigt die Spannung bis maximal zu dem Spannungswert der Spannungsquelle an und überschreitet den vorbestimmten Spannungsschwellenwert.

Der vorliegenden Erfindung liegt die Aufgabe zugrunde, ein Verfahren zum Feststellen eines elektrischen Fehlers eines Leitfähigkeitssensors, insbesondere von zumindest einem Elektrodenpaar des Leitfähigkeitssensors, bereitzustellen, das möglichst kontinuierlich während dem Betrieb des Leitfähigkeitssensors und ohne zusätzliche elektrische Elemente dafür durchgeführt werden kann.

Diese Aufgabe wird mit dem Verfahren gemäß Anspruch 1 und dem Leitfähigkeitssensor gemäß Anspruch 7 gelöst. Bevorzugte Ausgestaltungen sind in den Unteransprüchen angegeben.

Der vorliegenden Erfindung liegt im Wesentlichen der Gedanke zu Grunde, bei einem Leitfähigkeitssensor zum Ermitteln der elektrischen Leitfähigkeit eines Mediums, wie zum Beispiel Wasser für eine Wassereinspritzung bei einer Brennkraftmaschine für ein Fahrzeug, eine Überprüfung hinsichtlich der ordnungsgemäßen Funktionsfähigkeit des Leitfähigkeitssensors ohne zusätzliche elektrische Elemente durchzuführen. Der Leitfähigkeitssensor, der insbesondere ein Vierelektrodensensor sein kann, wird hierfür in seinem Betriebsmodus zum Ermitteln der elektrischen Leitfähigkeit des Mediums betrieben, wobei während dieses Betriebsmodus die Diagnose hinsichtlich der ordnungsgemäßen Leitfähigkeit dadurch durchgeführt werden kann, dass überprüft werden kann, ob das zumindest eine Elektrodenpaar ordnungsgemäß funktioniert. Insbesondere wird überprüft, ob das zumindest eine Elektrodenpaar kurzgeschlossen und/oder ein Leitungsbruch innerhalb der elektrischen Zuleitungen an das zumindest eine Elektrodenpaar vorliegt. Das wird beispielsweise durch Auswerten des sich mittels Anlegen einer Wechselspannung ergebenden Wechselstroms ermittelt.

Folglich ist gemäß einem ersten Aspekt der vorliegenden Erfindung ein Verfahren zum Feststellen eines elektrischen Fehlers eines Leitfähigkeitssensors zum Ermitteln der elektrischen Leitfähigkeit eines Mediums nach dem konduktiven Prinzip offenbart. Der Leitfähigkeitssensor weist ein erstes Elektrodenpaar, das dazu ausgebildet ist, vollständig im Medium angeordnet zu sein, und ein zweites Elektrodenpaar auf, das dazu ausgebildet ist, vollständig im Medium angeordnet zu sein. Das erfindungsgemäße Verfahren umfasst ein Anlegen einer elektrischen Wechselspannung am ersten Elektrodenpaar, ein Ermitteln des zeitlichen Verlaufs des sich in Erwiderung auf das Anlegen der elektrischen Wechselspannung am ersten Elektrodenpaar ergebenden elektrischen Wechselstroms am ersten Elektrodenpaar, ein Ermitteln eines Strom-Amplitudenkennwerts des ermittelten zeitlichen Verlaufs des elektrischen Wechselstroms und ein Feststellen eines elektrischen Fehlers des Leitfähigkeitssensors, wenn der ermittelte Strom-Amplitudenkennwert unterhalb eines ersten vorbestimmten Stromschwellenwerts oder oberhalb eines zweiten vorbestimmten Stromschwellenwerts ist. Wenn festgestellt wurde, dass kein elektrischer Fehler des ersten Elektrodenpaars vorliegt, das heißt, dass das erste Elektrodenpaar ordnungsgemäß funktioniert und elektrisch angesteuert werden kann, umfasst das erfindungsgemäße Verfahren ferner ein Ermitteln des zeitlichen Verlaufs der sich aufgrund der am ersten Elektrodenpaar angelegten Wechselspannung ergebenden elektrischen Wechselspannung am zweiten Elektrodenpaar, ein Ermitteln eines Spannungs-Amplitudenkennwerts des ermittelten zeitlichen Verlaufs der elektrischen Wechselspannung am zweiten Elektrodenpaar und ein Feststellen eines elektrischen Fehlers des zweiten Elektrodenpaars, wenn der ermittelte Spannungs-Amplitudenkennwert unterhalb eines vorbestimmten Spannungsschwellenwerts liegt. Dabei umfasst das Feststellen eines elektrischen Fehlers des zweiten Elektrodenpaars ein Ermitteln einer Phasenverschiebung zwischen der am ersten Elektrodenpaar angelegten Wechselspannung und der sich am zweiten Elektrodenpaar daraus ergebenden Wechselspannung, ein Feststellen eines Kurzschlusses zwischen den Elektroden des zweiten Elektrodenpaares, wenn die ermittelte Phasenverschiebung unterhalb eines vorbestimmten Phasenschwellenwerts liegt und ein Feststellen einer Unterbrechung in einer der elektrischen Zuleitungen zu den Elektroden des zweiten Elektrodenpaares, wenn die ermittelte Phasenverschiebung oberhalb des vorbestimmten Phasenschwellenwerts liegt.

Insbesondere wird sich dabei zu Nutze gemacht, dass es bei einem Kurzschluss kaum eine Phasenverschiebung zwischen dem zeitlichen Spannungsverlauf am ersten Elektrodenpaar und dem zeitlichen Spannungsverlauf am zweiten Elektrodenpaar gibt. Im Gegensatz dazu würde diese Phasenverschiebung bei einem Leitungsbruch ansteigen.

Das Anlegen der Wechselspannung am ersten Elektrodenpaar erfolgt dabei erfindungsgemäß während des Betriebs des Leitfähigkeitssensors, während dem die elektrische Leitfähigkeit des Mediums, insbesondere Wasser zur Wassereinspritzung bei einer Brennkraftmaschine eines Fahrzeugs, mittels dem Leitfähigkeitssensor erfasst wird. Insbesondere wird die zum Betrieb des Leitfähigkeitssensors am ersten Elektrodenpaar angelegte Wechselspannung gleichzeitig zur Diagnose der Funktionstüchtigkeit des Leitfähigkeitssensors, insbesondere des ersten Elektrodenpaares, verwendet.

Vorzugsweise weist das Feststellen eines elektrischen Fehlers des ersten Elektrodenpaares ein Feststellen eines Kurzschlusses zwischen den Elektroden des ersten Elektrodenpaares auf, wenn der ermittelte Strom-Amplitudenkennwert oberhalb des ersten vorbestimmten Stromschwellenwerts liegt. Zusätzlich oder alternativ weist das Feststellen eines elektrischen Fehlers des ersten Elektrodenpaares gemäß einer bevorzugten Ausführungsform des erfindungsgemäßen Verfahrens ein Feststellen einer Unterbrechung in einer der elektrischen Zuleitungen zu den Elektroden des ersten Elektrodenpaares auf, wenn der ermittelte Strom-Amplitudenkennwert unterhalb des zweiten vorbestimmten Stromschwellenwert liegt.

Insbesondere basiert die vorliegende Erfindung darauf, dass bei einem Kurzschluss zwischen den Elektroden des ersten Elektrodenpaares der sich aufgrund der am ersten Elektrodenpaar angelegten Wechselspannung ergebende Wechselstrom größer als der erste vorbestimmte Stromschwellenwert ist und somit eine ordnungsgemäße Messung der elektrischen Leitfähigkeit des Mediums nicht mehr gewährleistet werden kann. Im Gegensatz dazu führt eine Unterbrechung in einer der elektrischen Zuleitungen zu den Elektroden des ersten Elektrodenpaars dazu, dass der Wechselstrom unterhalb des zweiten vorbestimmten Stromschwellenwert liegt und somit wiederum keine ordnungsgemäße Messung der elektrischen Leitfähigkeit des Mediums durchgeführt werden kann. In einer beispielhaften Ausgestaltung beträgt der erste vorbestimmte Stromschwellenwert bei einer am ersten Elektrodenpaar angelegten Spannungsamplitude von ungefähr 0,5 V, abhängig vom Durchmesser der Stabelektroden und vom Abstand der Stabelektroden voneinander, ungefähr 0,1 mA und der zweite vorbestimmte Stromschwellenwert ungefähr 100 mA. Diese Werte für die beiden Stromschwellenwerte gelten beispielsweise für Stabelektroden mit einem Durchmesser von ungefähr 6 mm, einer Länge von ungefähr 4 mm und einem Abstand voneinander von ungefähr 8 mm.

In einer bevorzugten Ausgestaltung des erfindungsgemäßen Verfahrens entspricht der Strom-Amplitudenkennwert der Amplitude, dem Effektivwert oder dem Spitze-Spitze-Stromwert des zeitlichen Verlaufs des elektrischen Wechselstroms. Der Spitze-Spitze-Stromwert beschreibt dabei die Differenz zwischen Maximal- und Minimalwert des sinusförmigen zeitlichen Verlaufs des Wechselstroms, d.h. den Spitze-Tal-Wert.

In einer bevorzugten Ausgestaltung kann festgestellt werden, ob auch das zweite Elektrodenpaar ordnungsgemäß funktioniert und somit der gesamte, bevorzugt als Vierelektrodensensor ausgebildete, Leitfähigkeitssensor ordnungsgemäß betrieben werden kann. Die Überprüfung der Funktionsfähigkeit des zweiten Elektrodenpaares erfolgt selbstverständlich erst dann, wenn das erste Elektrodenpaar als funktionsfähig diagnostiziert worden ist. Nämlich erst durch das Anlegen der Wechselspannung am ersten Elektrodenpaar und des sich daraus ergebenden ordnungsgemäßen Wechselstroms am ersten Elektrodenpaar kann sich die Potentialdifferenz am zweiten Elektrodenpaar erst ergeben und es kann folglich auch erst dann ermittelt werden, ob ein elektrischer Fehler am zweiten Elektrodenpaar überhaupt vorliegt.

In einer beispielhaften Ausgestaltung beträgt der vorbestimmte Spannungsschwellenwert bei einer am ersten Elektrodenpaar angelegten Spannungsamplitude von ungefähr 0,5 V, abhängig vom Durchmesser der Stabelektroden und vom Abstand der Stabelektroden voneinander, ungefähr 0,1 V. Dieser Wert für den Spannungsschwellenwerte gilt beispielsweise für Stabelektroden mit einem Durchmesser von ungefähr 6 mm, einer Länge von ungefähr 4 mm und einem Abstand voneinander von ungefähr 8 mm In vorteilhafter Weise entspricht der Spannungs-Amplitudenkennwert der Amplitude, dem Effektivwert oder dem Spitze-Spitze-Spannungswert des zeitlichen Verlaufs der elektrischen Wechselspannung. Der Spitze-Spitze-Spannungswert beschreibt dabei die Differenz zwischen Maximal- und Minimalwert des sinusförmigen zeitlichen Verlaufs der sich am zweiten Elektrodenpaar ergebenden Wechselspannung, d.h. den Spitze-Tal-Wert.

Gemäß einem weiteren Aspekt der vorliegenden Erfindung ist außerdem ein Leitfähigkeitssensor zum Erfassen der elektrischen Leitfähigkeit eines Mediums nach dem konduktiven Prinzip offenbart. Der erfindungsgemäße Leitfähigkeitssensor weist ein erstes Elektrodenpaar, das dazu ausgebildet ist, vollständig im Medium angeordnet zu sein, ein zweites Elektrodenpaar, das dazu ausgebildet ist, vollständig im Medium angeordnet zu sein, und eine Steuereinheit auf, die mit dem ersten Elektrodenpaar und dem zweiten Elektrodenpaar elektrisch verbunden und dazu ausgebildet ist, ein Verfahren zum Feststellen des elektrischen Fehlers des Leitfähigkeitssensors gemäß einem erfindungsgemäßen Verfahren durchzuführen.

Weitere Vorteile und Ausgestaltungen der vorliegenden Erfindung werden dem Fachmann durch Ausüben der hierin beschriebenen Lehre und Betrachten der beiliegenden Zeichnungen ersichtlich, in denen:
- Fig. 1: eine schematische Ansicht eines erfindungsgemäßen Leitfähigkeitssensors mit einem ersten Elektrodenpaar und einem zweiten Elektrodenpaar zeigt,
- Fig. 2: ein Diagramm eines zeitlichen Verlaufs des sich am ersten Elektrodenpaar aufgrund einer am ersten Elektrodenpaar angelegten Wechselspannung ergebenden Wechselstroms zeigt,
- Fig. 3: ein beispielhaftes Ablaufdiagramm eines erfindungsgemäßen Verfahrens zum Feststellen eines elektrischen Fehlers des Leitfähigkeitssensors der Fig. 1 zeigt, und
- Fig. 4: ein beispielhaftes Ablaufdiagramm einer bevorzugten Ausgestaltung des erfindungsgemäßen Verfahrens zum Feststellen eines elektrischen Fehlers des Leitfähigkeitssensors der Fig. 1 zeigt.

Im Rahmen der vorliegenden Offenbarung beschreibt der Begriff "elektrischer Fehler" einen Fehlerzustand des Leitfähigkeitssensors hinsichtlich seiner elektrischen Bauelemente, insbesondere seiner Elektroden bzw. elektrischen Zuleitungen zu den Elektroden. Ein elektrischer Fehler kann beispielsweise in Form eines Kurzschlusses zwischen den Elektroden oder in Form einer Unterbrechung in den Zuleitungen zu den Elektroden vorliegen.

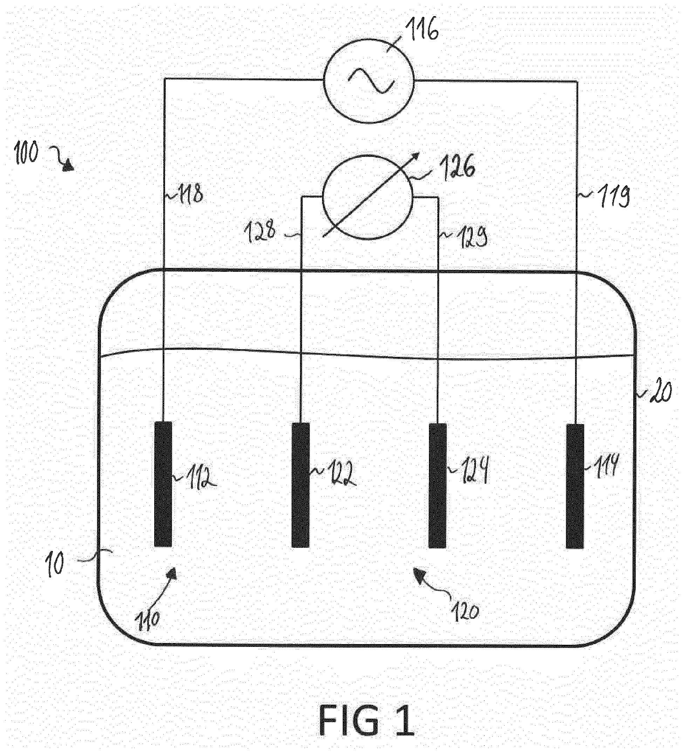

Die Fig. 1 zeigt eine schematische Ansicht eines erfindungsgemäßen Leitfähigkeitssensors 100. Der erfindungsgemäße Leitfähigkeitssensor 100 ist dazu ausgebildet, die elektrische Leitfähigkeit eines Mediums 10, das in einem Behälter 20 angeordnet ist, zu ermitteln. Das Medium ist beispielsweise Wasser, das zur Einspritzung in die Brennkammern einer Brennkraftmaschine eines Fahrzeugs eingespritzt werden kann. Alternativ kann das Medium auch eine wässrige Harnstofflösung sein, die in einem Harnstoffbehälter angeordnet und dazu ausgebildet ist, in einen Abgasstrang stromaufwärts eines SCR-Katalysators eingespritzt zu werden. Zudem kann es sich bei dem Medium um Alkohol, wie beispielsweise Ethanol, handeln, das in einem Alkoholbehälter untergebracht und dazu ausgebildet ist, in die Brennkammern der Brennkraftmaschine des Fahrzeugs eingespritzt zu werden.

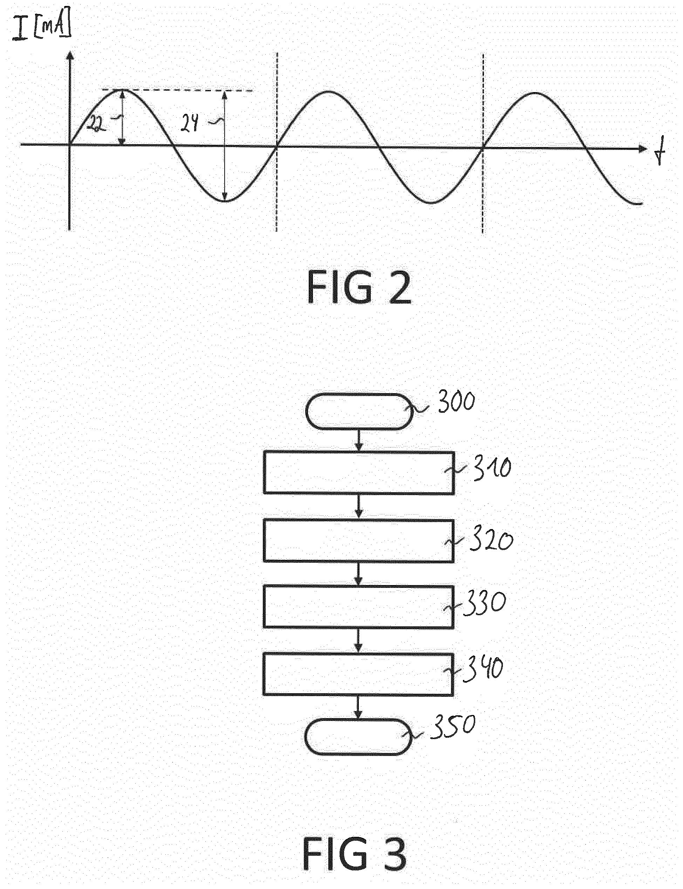

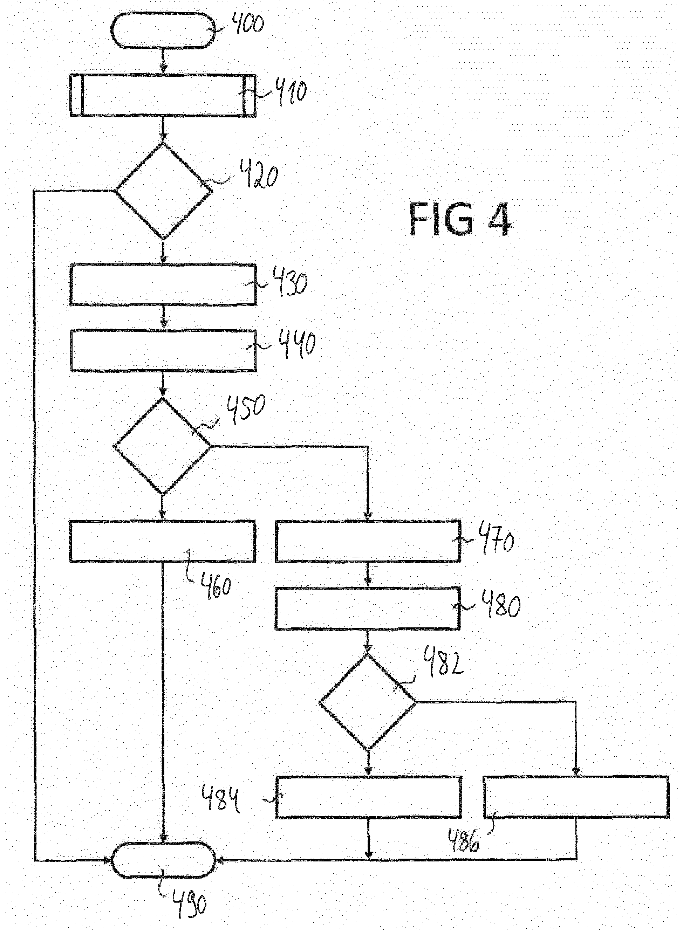

Der erfindungsgemäße Leitfähigkeitssensor 100 weist ein erstes Elektrodenpaar 110, ein zweites Elektrodenpaar 120 und eine Steuereinheit (in der Fig. 1 nicht explizit dargestellt) auf, die mit dem ersten Elektrodenpaar 110 und dem zweiten Elektrodenpaar 120 elektrisch verbunden und dazu ausgebildet ist, das erste Elektrodenpaar 110 und das zweite Elektrodenpaar 120 anzusteuern und die entsprechenden elektrischen Signale auszuwerten. Insbesondere ist die Steuereinheit dazu ausgebildet, das erfindungsgemäße Verfahren zum Feststellen eines elektrischen Fehlers eines Leitfähigkeitssensors 100, insbesondere des ersten Elektrodenpaares 110 und des zweiten Elektrodenpaares 120, durchzuführen, was weiter unten mit Bezug auf die Fig. 3 und 4 näher erläutert wird.

Der Leitfähigkeitssensor 100 der Fig. 1 ist als sogenannter Vierelektrodensensor ausgebildet. Das erste Elektrodenpaar 110 umfasst eine erste Elektrode 112 und eine zweite Elektrode 114, die unter einem vorbestimmten Abstand zueinander im Medium 10 angeordnet sind. Die erste Elektrode 112 und die zweite Elektrode 114 sind jeweils mit einer Spannungsquelle 116, insbesondere eine Wechselspannungsquelle, elektrisch über Zuleitungen 118, 119 verbunden.

Das zweite Elektrodenpaar 120 umfasst eine dritte Elektrode 122 und eine vierte Elektrode 124, die unter einem vorbestimmten Abstand zueinander im Medium 10 angeordnet sind. Die dritte Elektrode 122 und die vierte Elektrode 124 sind jeweils mit einem Messgerät 128, insbesondere ein Spannungsmessgerät, über elektrische Zuleitungen 128, 129 elektrisch verbunden.

Wie in der Fig. 1 gezeigt sind die Elektroden 122, 124 des zweiten Elektrodenpaars 120 zwischen den Elektroden 112, 114 des ersten Elektrodenpaares 110 angeordnet. Außerdem sind sämtliche Elektroden 112, 114, 122, 124 als Stabelektroden ausgebildet und dazu geeignet, vollständig im Medium 10 eingetaucht zu sein. Alternativ ist es jedoch möglich, wie es aus dem Stand der Technik für Leitfähigkeitssensoren, insbesondere Vierelektrodensensoren, bekannt ist, dass die Elektroden auch als konzentrisch zueinander angeordnete zylindrische Elektroden ausgebildet sind. Insbesondere ist es gemäß der vorliegenden Erfindung bedacht, dass die Form und Anordnung der Elektroden zueinander nicht auf die in der Fig. 1 gezeigte Ausgestaltung beschränkt ist, sondern dass die Form und Anordnung der Elektroden, wie es aus dem Stand der Technik für einen Leitfähigkeitssensor bekannt ist, ausgewählt werden können.

Das Messprinzip des Leitfähigkeitssensors 100 der Fig. 1 basiert auf dem konduktiven Prinzip, wie es aus dem Stand der Technik ebenfalls hinlänglich bekannt ist. Insbesondere wird mittels der Wechselspannungsquelle 160 an den Elektroden 112, 114 des ersten Elektrodenpaars 110 eine Wechselspannung angelegt und es wird dann der sich daraus ergebende Wechselstrom an den Elektroden 112, 114 des ersten Elektrodenpaares ermittelt. Zum Bereinigen von Grenz- bzw. Oberflächeneffekten wird zusätzlich das zweite Elektrodenpaar 120 dazu benutzt, diesen Störeffekten zum Erhöhen der Messgenauigkeit Rechnung zu tragen. Hierzu wird eine Potentialdifferenz zwischen den Elektroden 122, 124 des zweiten Elektrodenpaares 120 in Form einer Wechselspannung mittels dem Messgerät 126 ermittelt. Die Potentialdifferenz zwischen den Elektroden 122, 124 des zweiten Elektrodenpaares 120 stellt sich aufgrund der an den Elektroden 112, 114 des ersten Elektrodenpaares 120 angelegten Wechselspannung ein. Aus der ermittelten Potentialdifferenz zwischen den Elektroden 122, 124 des zweiten Elektrodenpaares und dem Wechselstrom an den Elektroden 112, 114 des ersten Elektrodenpaares, der sich aufgrund der daran angelegten Wechselspannung ergibt, kann dann der elektrische Widerstand des Mediums 10 ermittelt werden. Die elektrische Leitfähigkeit kann dann, unter Berücksichtigung der geometrischen Abmessungen der Elektroden, als Kehrwert des elektrischen Widerstands des Mediums ermittelt und bestimmt werden.

Die Fig. 2 zeigt einen beispielhaften zeitlichen Verlauf des sich am ersten Elektrodenpaar 110 aufgrund der am ersten Elektrodenpaar 110 angelegten Wechselspannung ergebenden Wechselstroms. Der zeitliche Verlauf des Wechselstroms in der Fig. 2 ist im Wesentlichen sinusförmig. In der Fig. 2 bezeichnet der Pfeil 22 die Amplitude des Wechselstroms und der Pfeil 24 beschreibt den Spitze-Spitze-Stromwert des Wechselstroms einer Schwingung. Die Amplitude 22 oder der Spitze-Spitze-Stromwert 24 können, wie es später unter Verweis auf die Fig. 3 näher erläutert wird, zur Überprüfung der Funktionalität des elektrischen Leitfähigkeitssensors herangezogen werden. Alternativ kann der Effektivwert des sinusförmigen Wechselstroms herangezogen werden.

Die Fig. 3 zeigt ein beispielhaftes Ablaufdiagramm eines erfindungsgemäßen Verfahrens zum Feststellen eines elektrischen Fehlers des erfindungsgemäßen Leitfähigkeitssensors 100. Das erfindungsgemäße Verfahren wird vorzugsweise erst dann durchgeführt, wenn festgestellt ist, dass sich die Elektroden 112, 114, 122, 124 des Leitfähigkeitssensors 100 vollständig im Medium 10 befinden. Dies kann z. B. durch Erfassen des Füllstands des Mediums 10 im Behälter 20 erfolgen. Wenn der Füllstand oberhalb eines vorbestimmten Füllstandschwellenwerts ist, kann daraus geschlossen werden, dass die Elektroden 112, 114, 122, 124 des Leitfähigkeitssensors 100 vollständig im Medium 10 eingetaucht sind. Das gleiche gilt für das Verfahren der Fig. 4, das weiter unten beschrieben wird.

Das Verfahren der Fig. 3 startet beim Schritt 300 und gelangt dann zu Schritt 310, bei dem, wie es für den ordnungsgemäßen Messbetrieb des elektrischen Leitfähigkeitssensors 100 bekannt ist, am ersten Elektrodenpaar 110 eine elektrische Wechselspannung angelegt wird. In einem darauffolgenden Schritt 320 wird, wie es ebenfalls für den ordnungsgemäßen Messbetrieb des elektrischen Leitfähigkeitssensors 100 bekannt ist, der zeitliche Verlauf des sich in Erwiderung auf das Anlegen der elektrischen Wechselspannung am ersten Elektrodenpaar 110 ergebenden elektrischen Wechselstroms am ersten Elektrodenpaar 110 ermittelt (siehe beispielsweise den zeitlichen Verlauf des Wechselstroms der Fig. 2).

Erfindungsgemäß wird in einem darauffolgenden Schritt 330 ein Strom-Amplitudenkennwert des ermittelten zeitlichen Verlaufs des elektrischen Wechselstroms ermittelt. Dabei kann beispielsweise die Amplitude 22 oder der Spitze-Spitze-Stromwert 24 (siehe Fig. 2) des zeitlichen Verlaufs des elektrischen Wechselstroms herangezogen werden. Alternativ kann, wie bereits beschriebe, der Effektivwert davon verwendet werden.

In einem weiteren darauffolgenden Schritt 340 wird ein elektrischer Fehler des ersten Elektrodenpaares 110 festgestellt, wenn der ermittelte Strom-Amplitudenkennwert unterhalb eines ersten vorbestimmten Stromschwellenwerts oder oberhalb eines zweiten vorbestimmten Stromschwellenwerts ist.

Insbesondere kann ein Kurzschluss zwischen den Elektroden 112, 114 des ersten Elektrodenpaares 110 festgestellt werden, wenn der ermittelte Strom-Amplitudenkennwert oberhalb des ersten vorbestimmten Stromschwellenwerts liegt. Insbesondere würde der bei einem Kurzschluss zwischen den Elektroden 112, 114 des ersten Elektrodenpaares 110 ein überdurchschnittlich hoher Stromwert gemessen werden, der dann als Kurzschluss identifiziert und als elektrischer Fehler des Leitfähigkeitssensors 100 interpretiert werden kann.

Wenn jedoch der ermittelte Strom-Amplitudenkennwert unterhalb des zweiten vorbestimmten Stromschwellenwerts liegt, kann auf eine Unterbrechung in einer der elektrischen Zuleitungen 118, 119 zu den Elektroden 112, 114 des ersten Elektrodenpaares 110 geschlossen werden. Eine solche Unterbrechung führt nämlich dazu, dass kein oder nur noch ein äußerst geringer Strom zwischen den Elektroden 112, 114 des ersten Elektrodenpaares 110 fließen kann und somit auch die dort angelegte Wechselspannung nicht mehr ordnungsgemäß angelegt werden kann.

Erfindungsgemäß ist es weiterhin vorgesehen, dass nach einem Feststellen der ordnungsgemäßen Funktionstüchtigkeit des ersten Elektrodenpaares 110 des Leitfähigkeitssensors 100 zusätzlich noch die Funktionstüchtigkeit des zweiten Elektrodenpaares 120 des Leitfähigkeitssensors überprüft wird. Die Fig. 4 zeigt hierfür ein beispielhaftes Ablaufdiagramm für ein entsprechendes Verfahren.

Das Verfahren der Fig. 4 startet beim Schritt 400 und gelangt dann zum Schritt 410, bei dem das Verfahren gemäß der Fig. 3 zum Ermitteln der Funktionstüchtigkeit des ersten Elektrodenpaares 110 des Leitfähigkeitssensors 100 durchgeführt wird. In einem darauffolgenden Schritt 420 wird abgefragt, ob beim Verfahren der Fig. 3 ein elektrischer Fehler des ersten Elektrodenpaares 110 des Leitfähigkeitssensors 100 festgestellt worden ist. Wenn beim Schritt 420 ein elektrischer Fehler des ersten Elektrodenpaares 110 festgestellt wird, gelangt das Verfahren zum Schritt 490 und wird beendet. Denn nur bei ordnungsgemäßem Funktionieren des ersten Elektrodenpaares 110 des Leitfähigkeitssensors 100 kann die elektrische Funktionstüchtigkeit des zweiten Elektrodenpaares 120 des Leitfähigkeitssensors 100 überprüft werden.

Wird beim Schritt 420 aber festgestellt, dass kein elektrischer Fehler des ersten Elektrodenpaares 110 des Leitfähigkeitssensors 100 vorliegt, gelangt das Verfahren der Fig. 4 zum Schritt 430, an dem der zeitliche Verlauf der sich aufgrund der am ersten Elektrodenpaar 110 angelegten Wechselspannung ergebenden elektrischen Wechselspannung am zweiten Elektrodenpaar 120 des Leitfähigkeitssensors 100 ermittelt wird, wie es auch im ordnungsgemäßen Messbetrieb des Leitfähigkeitssensors 100 gemacht wird.

Daraufhin wird beim Schritt 440 ein Spannungs-Amplitudenkennwert des ermittelten zeitlichen Verlaufs der elektrischen Wechselspannung am zweiten Elektrodenpaar 120 des Leitfähigkeitssensors 100 ermittelt. In einem darauffolgenden Schritt 450 wird überprüft, ob der ermittelte Spannungs-Amplitudenkennwert unterhalb eines vorbestimmten Spannungsschwellenwerts ist. Wenn beim Schritt 450 festgestellt wird, dass der ermittelte Spannungs-Amplitudenkennwert größer als der vorbestimmte Spannungsschwellenwert ist, gelangt das Verfahren zum Schritt 460, an dem das zweite Elektrodenpaar 120 des Leitfähigkeitssensors 100 als funktionstüchtig bestimmt wird, bevor das Verfahren beim Schritt 490 endet.

Wenn jedoch beim Schritt 450 festgestellt wird, dass der ermittelte Spannungs-Amplitudenkennwert kleiner als der vorbestimmte Spannungsschwellenwert ist, gelangt das Verfahren zum Schritt 470, an dem zunächst ein elektrischer Fehler des zweiten Elektrodenpaares 120 des Leitfähigkeitssensors 100 ermittelt wird. In einem darauffolgenden Schritt 480 wird eine Phasenverschiebung zwischen der am ersten Elektrodenpaar 110 des Leitfähigkeitssensors 100 angelegten Wechselspannung und der sich dadurch am zweiten Elektrodenpaar 120 des Leitfähigkeitssensors 100 ergebenden Wechselspannung ermittelt.

Wird an einem darauffolgenden Schritt 482 bestimmt, dass die ermittelte Phasenverschiebung kleiner ist als ein vorbestimmter Phasenschwellenwert, gelangt das Verfahren zum Schritt 484, an dem ein Kurzschluss zwischen den Elektroden 122, 124 des zweiten Elektrodenpaares 120 des Leitfähigkeitssensors 100 festgestellt wird, bevor das Verfahren am Schritt 490 endet. Der Phasenschwellenwert beträgt beispielsweise ungefähr 10°.

Wird jedoch am Schritt 482 bestimmt, dass die ermittelte Phasenverschiebung größer ist als der vorbestimmte Phasenschwellenwert, gelangt das Verfahren zum Schritt 486, an dem eine Unterbrechung in einer der elektrischen Zuleitungen 128, 128 zu den Elektroden 122, 124 des zweiten Elektrodenpaares 120 des Leitfähigkeitssensors 100 festgestellt wird, bevor das Verfahren am Schritt 490 endet.

Insbesondere macht sich dabei die Erfindung zu Nutze, dass bei einem Kurzschluss zwischen den Elektroden 122, 124 des zweiten Elektrodenpaares 120 des Leitfähigkeitssensors 100 kaum eine Phasenverschiebung zwischen dem zeitlichen Spannungsverlauf am ersten Elektrodenpaar 110 und dem zeitlichen Spannungsverlauf am zweiten Elektrodenpaar 110 vorhanden ist. Im Gegensatz dazu würde diese Phasenverschiebung bei einem Leitungsbruch ansteigen.

Mit dem erfindungsgemäßen Verfahren und dem erfindungsgemäßen Leitfähigkeitssensor 100 kann dauerhaft während dem Betrieb des Leitfähigkeitssensors 100 eine Diagnose, wie beispielsweise eine OBD-Diagnose, hinsichtlich der Funktionstüchtig des Leitfähigkeitssensors 100 gemacht werden, ohne dabei separate elektrische Bauelemente und Schaltungen vorzusehen. Außerdem kann die Diagnose während dem laufenden Betrieb des Leitfähigkeitssensors 100 erfolgen, so dass dieser für Diagnosezwecke nicht unterbrochen werden muss.

## Patentansprüche

1. Verfahren zum Feststellen eines elektrischen Fehlers eines Leitfähigkeitssensors (100) zum Ermitteln der elektrischen Leitfähigkeit eines Mediums nach dem konduktiven Prinzip, wobei der Leitfähigkeitssensor (100) ein erstes Elektrodenpaar (110), das dazu ausgebildet ist, vollständig im Medium angeordnet zu sein, und ein zweites Elektrodenpaar (120) aufweist, das dazu ausgebildet ist, vollständig im Medium angeordnet zu sein, wobei das Verfahren umfasst:
- Anlegen einer elektrischen Wechselspannung am ersten Elektrodenpaar (110),
- Ermitteln des zeitlichen Verlaufs des sich in Erwiderung auf das Anlegen der elektrischen Wechselspannung am ersten Elektrodenpaar (110) ergebenden elektrischen Wechselstroms am ersten Elektrodenpaar (110),
- Ermitteln eines Strom-Amplitudenkennwerts des ermittelten zeitlichen Verlaufs des elektrischen Wechselstroms, und
- Feststellen eines elektrischen Fehlers des Leitfähigkeitssensors (100), wenn der ermittelte Strom-Amplitudenkennwert unterhalb eines ersten Stromschwellenwerts oder oberhalb eines zweiten Stromschwellenwerts ist,
wobei das Verfahren, wenn festgestellt wurde, dass kein elektrischer Fehler des ersten Elektrodenpaares (110) vorliegt, ferner aufweist:
Ermitteln des zeitlichen Verlaufs der sich aufgrund der am ersten Elektrodenpaar (110) angelegten Wechselspannung ergebenden elektrischen Wechselspannung am zweiten Elektrodenpaar (120),
- Ermitteln eines Spannungs-Amplitudenkennwerts des ermittelten zeitlichen Verlaufs der elektrischen Wechselspannung am zweiten Elektrodenpaar (120), und
- Feststellen eines elektrischen Fehlers des zweiten Elektrodenpaares (120), wenn der ermittelte Spannungs-Amplitudenkennwert unterhalb eines Spannungsschwellenwerts liegt,
wobei das Feststellen eines elektrischen Fehlers des zweiten Elektrodenpaares (120) aufweist:
- Ermitteln einer Phasenverschiebung zwischen der am ersten Elektrodenpaar (110) angelegten Wechselspannung und der sich am zweiten Elektrodenpaar (120) daraus ergebenden Wechselspannung,
- Feststellen eines Kurzschlusses zwischen den Elektroden (122, 124) des zweiten Elektrodenpaares (120), wenn die ermittelte Phasenverschiebung unterhalb eines vorbestimmten Phasenschwellenwerts liegt, und
- Feststellen einer Unterbrechung in einer der elektrischen Zuleitungen zu den Elektroden (122, 124) des zweiten Elektrodenpaares (120), wenn die ermittelte Phasenverschiebung oberhalb des vorbestimmten Phasenschwellenwerts liegt.

2. Verfahren nach Anspruch 1, wobei das Feststellen eines elektrischen Fehlers des Leitfähigkeitssensors (110) aufweist:
- Feststellen eines Kurzschlusses zwischen den Elektroden (112, 114) des ersten Elektrodenpaares (110), wenn der ermittelte Strom-Amplitudenkennwert oberhalb des ersten Stromschwellenwerts liegt, und/oder
- Feststellen einer Unterbrechung in einer der elektrischen Zuleitungen zu den Elektroden (112, 114) des ersten Elektrodenpaares (110), wenn der ermittelte Strom-Amplitudenkennwert unterhalb des zweiten Stromschwellenwerts liegt.

3. Verfahren nach einem der vorhergehenden Ansprüche, wobei der erste Stromschwellenwert und/oder zweite Stromschwellenwert abhängig vom angelegten Spannungsamplitudenwert und der Geometrie der Elektroden (112, 114) des ersten Elektrodenpaares (110) vorbestimmt werden.

4. Verfahren nach einem der vorhergehenden Ansprüche, wobei der Strom-Amplitudenkennwert der Amplitude, dem Effektivwert oder dem Spitze-Spitze-Stromwert des zeitlichen Verlaufs des elektrischen Wechselstroms entspricht.

5. Verfahren nach einem der vorhergehenden Ansprüche, wobei der Spannungsschwellenwert abhängig von dem am ersten Elektrodenpaar (110) angelegten Spannungsamplitudenwert und der Geometrie der Elektroden (122, 124) des ersten und zweiten Elektrodenpaares (120) vorbestimmt wird.

6. Verfahren nach einem der vorhergehenden Ansprüche, wobei der Spannungs-Amplitudenkennwert der Amplitude, dem Effektivwert oder dem Spitze-Spitze-Spannungswert des zeitlichen Verlaufs der elektrischen Wechselspannung entspricht.

7. Leitfähigkeitssensor (100) zum Erfassen der elektrischen Leitfähigkeit eines Mediums nach dem konduktiven Prinzip, wobei der Leitfähigkeitssensor (100) aufweist:
- ein erstes Elektrodenpaar (110), das dazu ausgebildet ist, vollständig im Medium angeordnet zu sein,
- ein zweites Elektrodenpaar (120), das dazu ausgebildet ist, vollständig im Medium angeordnet zu sein, und
- eine Steuereinheit, die mit dem ersten Elektrodenpaar (110) und dem zweiten Elektrodenpaar (120) elektrisch verbunden und dazu ausgebildet ist, ein Verfahren zum Feststellen eines elektrischen Fehlers des Leitfähigkeitssensors (100) nach einem der vorhergehenden Ansprüchen durchzuführen.

## Claims

1. Method for determining an electrical fault of a conductivity sensor (100) for ascertaining the electrical conductivity of a medium in accordance with the conductivity principle, wherein the conductivity sensor (100) comprises a first electrode pair (110) that is designed to be fully disposed in the medium and a second electrode pair (120) that is designed to be fully disposed in the medium, wherein the method comprises:
- applying an electrical alternating voltage to the first electrode pair (110),
- ascertaining the temporal profile of the electrical alternating current at the first electrode pair (110) resulting in response to the application of the electrical alternating voltage at the first electrode pair (110),
- ascertaining a current-amplitude characteristic value of the ascertained temporal profile of the electrical alternating current, and
- determining an electrical fault of the conductivity sensor (100) if the ascertained current-amplitude characteristic value is below a first current threshold value or above a second current threshold value,
wherein the method, if it was determined that no electrical fault of the first electrode pair (110) is present, further comprises:
ascertaining the temporal profile of the electrical alternating voltage at the second electrode pair (120) resulting from the alternating voltage applied at the first electrode pair (110),
- ascertaining a voltage-amplitude characteristic value of the ascertained temporal profile of the electrical alternating voltage at the second electrode pair (120), and
- determining an electrical fault of the second electrode pair (120) if the ascertained voltage-amplitude characteristic value lies below a voltage threshold value,
wherein the determination of an electrical fault of the second electrode pair (120) comprises:
- ascertaining a phase shift between the alternating voltage applied at the first electrode pair (110) and the alternating voltage resulting from it at the second electrode pair (120),
- determining a short circuit between the electrodes (122, 124) of the second electrode pair (120) if the ascertained phase shift lies below a predetermined phase threshold value, and
- determining a break in one of the electrical supply lines to the electrodes (122, 124) of the second electrode pair (120) if the ascertained phase shift lies above the predetermined phase threshold value.

2. Method according to Claim 1, wherein the determination of an electrical fault of the conductivity sensor (110) comprises:
- determining a short circuit between the electrodes (112, 114) of the first electrode pair (110) if the ascertained current-amplitude characteristic value lies above the first current threshold value, and/or
- determining a break in one of the electrical supply lines to the electrodes (112, 114) of the first electrode pair (110) if the ascertained current-amplitude characteristic value lies below the second current threshold value.

3. Method according to either of the preceding claims, wherein the first current threshold value and/or the second current threshold value are/is predetermined depending on the applied voltage amplitude value and the geometry of the electrodes (112, 114) of the first electrode pair (110).

4. Method according to one of the preceding claims, wherein the current-amplitude characteristic value corresponds to the amplitude, the root-mean-square value or the peak-to-peak current value of the temporal profile of the electrical alternating current.

5. Method according to one of the preceding claims, wherein the voltage threshold value is predetermined depending on the voltage amplitude value applied at the first electrode pair (110) and the geometry of the electrodes (122, 124) of the first and second electrode pairs (120).

6. Method according to one of the preceding claims, wherein the voltage-amplitude characteristic value corresponds to the amplitude, the root-mean-square value or the peak-to-peak voltage value of the temporal profile of the electrical alternating voltage.

7. Conductivity sensor (100) for capturing the electrical conductivity of a medium in accordance with the conductivity principle, wherein the conductivity sensor (100) comprises:
- a first electrode pair (110) that is designed to be fully disposed in the medium,
- a second electrode pair (120) that is designed to be fully disposed in the medium, and
- a control unit that is electrically connected to the first electrode pair (110) and the second electrode pair (120) and that is designed to carry out a method for determining an electrical fault of the conductivity sensor (100) according to one of the preceding claims.

## Revendications

1. Procédé pour détecter un dysfonctionnement électrique d'un capteur de conductivité (100) destiné à déterminer la conductivité électrique d'un milieu selon le principe de conduction, le capteur de conductivité (100) comportant une première paire d'électrodes (110) qui est conçue pour être disposée intégralement dans le milieu, et une seconde paire d'électrodes (120) qui est conçue pour être disposée intégralement dans le milieu, le procédé comprenant :
- l'application d'une tension électrique alternative à la première paire d'électrodes (110),
- la détermination au niveau de la première paire d'électrodes (110) de la variation dans le temps du courant électrique alternatif résultant de l'application de la tension électrique alternative à la première paire d'électrodes (110),
- la détermination d'une caractéristique d'amplitude de courant de la variation dans le temps déterminée du courant électrique alternatif, et
- la détection d'un dysfonctionnement électrique du capteur de conductivité (100) lorsque la valeur caractéristique d'amplitude de courant détectée est inférieure à une première valeur de seuil de courant ou supérieure à une seconde valeur de seuil de courant,
dans lequel, lorsqu'il a été détecté qu'il ne se produit aucun dysfonctionnement électrique de la première paire d'électrodes (110), le procédé comprend en outre :
la détermination au niveau de la seconde paire d'électrodes (120) de la variation dans le temps de la tension électrique alternative résultant de la tension alternative appliquée à la première paire d'électrodes (110),
- la détermination au niveau de la seconde paire d'électrodes (120) d'une valeur caractéristique d'amplitude de tension de la variation dans le temps déterminée de la tension électrique alternative, et
- la détection d'un dysfonctionnement électrique de la seconde paire d'électrodes (120) lorsque la valeur caractéristique d'amplitude de tension déterminée est inférieure à une valeur de seuil de tension,
dans lequel la détection d'un dysfonctionnement électrique de la seconde paire d'électrodes (120) comprend :
- la détermination d'un déphasage entre la tension alternative appliquée à la première paire d'électrodes (110) et la tension alternative qui en résulte au niveau de la seconde paire d'électrodes (120),
- la détection d'un court-circuit entre les électrodes (122, 124) de la seconde paire d'électrodes (120) lorsque le déphasage déterminé est inférieur à une valeur de seuil de phase prédéterminée, et
- la détection d'une interruption dans l'une des lignes d'alimentation électriques menant aux électrodes (122, 124) de la seconde paire d'électrodes (120) lorsque le déphasage déterminé est supérieur à la valeur de seuil de phase prédéterminée.

2. Procédé selon la revendication 1, dans lequel la détection d'un dysfonctionnement électrique du capteur de conductivité (110) comprend :
- la détection d'un court-circuit entre les électrodes (112, 114) de la première paire d'électrodes (110) lorsque la valeur caractéristique d'amplitude de courant déterminée est supérieure à la première valeur de seuil de courant, et/ou
- la détection d'une interruption dans l'une des lignes d'alimentation électriques menant aux électrodes (112, 114) de la première paire d'électrodes (110) lorsque la valeur caractéristique d'amplitude de courant déterminée est inférieure à la seconde valeur de seuil de courant.

3. Procédé selon l'une des revendications précédentes, dans lequel la première valeur de seuil de courant et/ou la seconde valeur de seuil de courant sont prédéterminées en fonction de la valeur d'amplitude de tension appliquée et de la géométrie des électrodes (112, 114) de la première paire d'électrodes (110).

4. Procédé selon l'une des revendications précédentes, dans lequel la valeur caractéristique d'amplitude de courant correspond à l'amplitude, à la valeur efficace ou à la valeur de courant crête-à-crête de la variation dans le temps du courant électrique alternatif.

5. Procédé selon l'une des revendications précédentes, dans lequel la valeur de seuil de tension est prédéterminée en fonction de la valeur d'amplitude de tension appliquée à la première paire d'électrodes (110) et de la géométrie des électrodes (122, 124) des première et deuxième paires d'électrodes (120).

6. Procédé selon l'une des revendications précédentes, dans lequel la valeur caractéristique d'amplitude de tension correspond à l'amplitude, à la valeur efficace ou à la valeur de tension crête-à-crête de la variation dans le temps de la tension électrique alternative.

7. Capteur de conductivité (100) destiné à détecter la conductivité électrique d'un milieu selon le principe de conduction, dans lequel le capteur de conductivité (100) comporte :
- une première paire d'électrodes (110) qui est conçue pour être disposée intégralement dans le milieu,
- une seconde paire d'électrodes (120) qui est conçue pour être disposée intégralement dans le milieu, et
- une unité de commande connectée électriquement à la première paire d'électrodes (110) et à la seconde paire d'électrodes (120) et conçue pour mettre en œuvre un procédé pour détecter un dysfonctionnement électrique du capteur de conductivité (100) selon l'une quelconque des revendications précédentes.
